# EUROPEAN PATENT APPLICATION

(11) **EP 4 455 359 A1**
(43) Date of publication of application: **30.10.2024**
(21) Application number: 23817935.2
(22) Date of filing: 29.05.2023
(51) Int. Cl.: C23C 14/56, C23C 14/50, H01G 13/00

(54) **VAPOR DEPOSITION FILM PRODUCTION DEVICE**

(30) Priority: 14.03.2023 JP 2023039637
(71) Applicant: Machine Technology Co., Ltd., Shimane 690-0816 (JP)
(72) Inventor: KASEBE, Tsuyoshi, Matsue-shi, Shimane 6900816 (JP); MIYAKE, Toru, Matsue-shi, Shimane 6900816 (JP)
(74) Representative: Hoffmann Eitle
(86) International application number: PCT/JP2023/019864
(87) International publication number: WO 2024/189933

(57) **Abstract**

Provided is a vapor deposition film manufacturing apparatus (1) which is partitioned into an upper chamber (10U) and a lower chamber (10D) with a can-roller (cooling roller) (201) provided therebetween, including: a lower-chamber vacuum unit (500); an upper-chamber vacuum unit (400); an electron supply chamber (601) which houses therein a hollow cathode (611); a valve (621) configured to supply gas for ionization while maintaining an inside of the electron supply chamber (601) at a predetermined vacuum degree; and a power supply (603) configured to ionize gas inside the electron supply chamber (601). A slit (613) is provided in the electron supply chamber (601) so as to be opened toward a surface of the roller (201). A diffusion preventing cover (604) is provided to prevent rebound electrons from diffusing from the roller (201) side. Adhesiveness of the film is enhanced by properly charging the surface of the roller (201).

## Description

### Technical Field

The present invention relates to a vapor deposition film manufacturing apparatus for manufacturing a high-quality metal vapor deposition film, which involves suppressing an adverse influence due to occurrence of unintended discharge while increasing the degree of adhesion of a dielectric film to a can-roller (cooling roller). More particularly, the present invention relates to a vapor deposition film manufacturing apparatus using a hollow cathode and thus not causing an increase in size of the apparatus.

### Background Art

Hitherto, as an apparatus for manufacturing a film for a film capacitor, that is, a metal vapor deposition dielectric film, there has been known an apparatus using a can-roller. In such an apparatus, a strip-shaped resin film being continuously supplied is fed while abutting against the can-roller in an area corresponding to a predetermined central angle (wrap angle), and metal vapor deposition is performed on the abutting portion.

The film is thin, and a temperature thereof substantially corresponds to a surface temperature of the can-roller. Thus, in order to prevent thermal damage of the film during the metal vapor deposition, a mechanism for cooling the can-roller is employed. Accordingly, a quality of a metal vapor deposition film is improved.

Moreover, when the degree of adhesion of the film to the can-roller is high, uniform and rapid cooling is achieved. Thus, a mechanism for charging the can-roller is also employed. The mechanism energizes a tungsten wire arranged so as to extend above the can-roller longitudinally in an axial direction of the can-roller, and the energization of the tungsten wire causes generation of thermoelectrons, thereby charging the can-roller.

Further, typically, an inside of a chamber is partitioned into an upper chamber and a lower chamber with the can-roller provided therebetween, and vacuum is adjusted so that the lower chamber in which metal vapor deposition is to be performed is maintained at a pressure of about 10⁻² Pa (Pa: pascal) or less, and the upper chamber is maintained at a pressure of about 10⁻¹ Pa.

In this case, a combination of, for example, a mechanical booster pump and a rotary pump is employed as a vacuum pump for the upper chamber, and in the lower chamber, an oil diffusion pump is further combined with those pumps, thereby achieving high vacuum.

In general, vacuuming in a larger number of stages is required as a vacuum degree is set higher. In a vapor deposition film manufacturing apparatus using a can-roller, substantially, two sets of vacuum pump systems for the upper chamber and the lower chamber, respectively, are required. This is because, compared to a case of introducing a vacuum pump system for setting a pressure of the entire inside of the chamber to about 10⁻² Pa or less without providing a partition therein, an increase in size of a configuration of the entire apparatus can be prevented, and it is possible to introduce the apparatus at low cost.

However, in the case of charging the can-roller, while it is required to emit electrons from a wire on the upper chamber side where the film is not wrapped, an atmospheric pressure is about 10⁻¹ Pa, resulting in a problem in that abnormal discharge occurs.

In order to avoid the problem, it is required to introduce a third vacuum pump system to set a pressure of at least only a vicinity of the wire to about 10⁻² Pa, or to introduce a large-sized pump system for setting a pressure of the entire upper chamber to about 10⁻² Pa at which abnormal discharge does not occur, resulting in a problem of eventually causing an increase in size of the apparatus configuration (as a result, the apparatus is also increased in cost).

### Citation List

### Patent Literature

[PTL 1] JP 2003-308609 A

### Summary of Invention

### Technical Problem

The present invention has been made in view of the above, and an object thereof is to provide a vapor deposition film manufacturing apparatus for manufacturing a high-quality metal vapor deposition film without causing an increase in size of the apparatus.

### Solution to Problem

A vapor deposition film manufacturing apparatus described in claim 1 is a vapor deposition film manufacturing apparatus which is partitioned into an upper chamber and a lower chamber with a cooling roller, which is also called can-roller, having a circular column shape provided therebetween, the cooling roller being arranged so that an axis thereof is horizontal, and being configured to rotate to feed a dielectric film having a strip shape while causing the dielectric film to abut against the cooling roller over a predetermined central angle on the lower chamber side, the vapor deposition film manufacturing apparatus including: a evaporation unit, which is arranged in the lower chamber, and is configured to diffuse metal vapor toward the dielectric film; a lower-chamber vacuum pump, which is in communication with the lower chamber, and is configured to maintain the lower chamber at a first predetermined vacuum degree; an upper-chamber vacuum pump, which is in communication with the upper chamber, and is configured to maintain the upper chamber at a second predetermined vacuum degree; an electron supply chamber, which houses therein a hollow cathode, has a columnar outer shape, and is arranged so that a longitudinal direction of the electron supply chamber is parallel to the axis; a gas supply unit configured to supply gas for ionization into the electron supply chamber; chamber-inside pressure control unit for maintaining an inside of the electron supply chamber at a third predetermined vacuum degree; and a power supply unit configured to ionize gas inside the electron supply chamber via the hollow cathode. A slit for electron emission is provided in the electron supply chamber so as to be parallel to the axis, and is opened toward a portion of a surface of the cooling roller, which is not covered with the dielectric film. A prevention body is provided between the electron supply chamber and the cooling roller, and is configured to prevent electrons from diffusing to the upper chamber side due to rebound of the electrons from the cooling roller side. While adhesiveness of the dielectric film to the cooling roller is enhanced by charging the surface of the cooling roller, occurrence of unintended discharge in the upper chamber is suppressed.

That is, according to the invention of claim 1, there is used the electron supply chamber housing the hollow cathode, in which electrons ionized in an atmosphere with a pressure higher than the vacuum degree of the upper chamber are accelerated to be emitted. Thus, the degree of adhesion of the film can be suitably increased without causing an increase in size of the apparatus. In addition, electrons are suppressed from spreading inside the upper chamber due to rebound of the electrons from the cooling roller side. Thus, a possibility of occurrence of unintended discharge is reduced. Accordingly, it is possible to provide a metal vapor deposition film with a high quality and high reliability.

A size of the cooling roller is only required to be appropriately designed, and can be set to, for example, a diameter of from 50 cm to 70cm, and an axial length (width) of from 350 mm to 950 mm. Further, in order that the cooling roller is efficiently charged, the surface thereof is preferably covered with a dielectric layer (insulating layer), and as an example, such a layer can be formed of ceramics. Examples of the ceramics may include only alumina, alumina and titania (a mixed ceramics of alumina and titania, part of alumina and titania may be changed to aluminum titanate), and only titania. The thickness of the insulating layer may be, for example, from 30 um to 100 um.

Examples of the material of the dielectric film may include polypropylene (PP), polyphenylene sulfide (PPS), polyvinylidene fluoride (PVDF), polyethylene terephthalate (PET), and polyimide. In addition, the thickness thereof may be, for example, from 1.5 um to 50 um, and the width thereof may be, for example, from 300 mm to 900 mm.

The first predetermined vacuum degree is only required to be a vacuum degree suitable for metal vapor deposition, and as an example, can be set to (0.5 to 50)×10⁻² Pa. The first predetermined vacuum degree is in an order of about 10⁻² Pa as a standard.

The second predetermined vacuum degree is only required to be appropriately designed in consideration of leakage of ionized gas from the electron supply chamber into the upper chamber, and a pressure difference between the upper chamber and the lower chamber, and as an example, can be set to (0.5 to 50)×10⁻¹ Pa. The second predetermined vacuum degree is in an order of about 10⁻¹ Pa as a standard.

Although depending on a slit width, a potential difference, a supply amount of gas, a vacuum degree of the upper chamber, and the like, as an example, the third predetermined vacuum degree can be set to from 0.5 Pa to 100 Pa. The third predetermined vacuum degree is in an order of about 10⁺¹ Pa as a standard.

As an example, the gas for ionization can be rare gas having poor reactivity with a film and a metal, for example, Ar.

A voltage from the power supply unit is not particularly limited as long as the voltage can cause gas to be efficiently ionized and also cause electrons to be accelerated so as to be continuously and stably injected from the slit. As an example, the voltage can be set to a DC voltage of from -4 kV to -16 kV with respect to a cathode (slit portion is grounded).

As an example, an interval of the slit can be set to from 0.1 mm to 1.5 mm. With this interval, electrons can be properly and continuously injected onto a portion of the surface of the cooling roller, with which the film is not in contact. Further, so to speak, a steady electron beam is supplied, and hence, even when electrons escape to the film side, an attraction force between the surface of the cooling roller and the film is kept, thereby enabling a high-quality vapor deposition film to be produced.

When the slit width is narrow, the electron beam substantially does not spread and linearly hits the surface of the cooling roller. A distance between the slit and the surface of the cooling roller can be set to, for example, from 20 cm to 30 cm.

A pressure PD of the lower chamber at the time of manufacturing a metal vapor deposition film is in an order of about 10⁻² Pa, and based thereon, a pressure and a size of each of places are determined, and the slit width is thus also determined substantially as an absolute value. However, a slit width "w" with respect to a sectional area S of the hollow cathode or the electron supply chamber satisfies 1,000≤S/w≤50,000 as a standard.

In this case, it is desired that all of electrons adhere to the surface of the cooling roller, but actually, rebound of a part of the electrons occurs. In this case, a portion in which electrons are liable to collect is sometimes generated due to a shape of the upper chamber and arrangement of each of parts, which causes abnormal discharge.

When a film is subjected to abnormal discharge, a vapor deposition film is naturally damaged, for example. Even when the film is not directly subjected to abnormal discharge, each of parts is affected, and degradation in quality of the film is indirectly caused.

Accordingly, the prevention body is provided for receiving such rebound of the electrons. For example, the prevention body can be formed as a prevention plate which is curved so as to follow an outer shape of the cooling roller. For example, the prevention body may be appropriately grounded, or the prevention body and the cooling roller may be brought into contact with each other so that the prevention body has a potential equal to that of the cooling roller.

According to the vapor deposition film manufacturing apparatus described in claim 2, in the vapor deposition film manufacturing apparatus described in claim 1, a guide body is provided in the upper chamber, and is configured to direct gas positively charged and leaked out from the slit, to a predetermined direction.

That is, according to the invention of claim 2, gas is transferred to the portion in which electrons are liable to collect, so as to eliminate a potential difference, and thus, occurrence of unintended discharge is further suppressed. Abnormal discharge may be prevented by intentionally causing gas to flow toward a portion in which it is particularly desired to prevent occurrence of abnormal discharge.

Even when the prevention body is provided, a part of electrons is diffused inside the upper chamber and collects in a portion in which electrons easily collect. The guide body causes gas positively charged and leaked out from the slit to direct to such a portion so that the portion is neutralized.

The guide body may be a plate-shaped directing plate, or may have a shape with a throttle as in a funnel. Further, the guide body may be also formed into a shape of a tubular directing port being in communication with the electron supply chamber and extending from the slit side (while preventing interference of the guide body with an electron beam).

It is preferred that the guide body be arranged in a vicinity of the slit, and the prevention body be arranged in a vicinity of the cooling roller. However, the guide body and the prevention body may be formed as an integrated body such that the guide body serves as an upper surface and the prevention body serves as a lower surface.

According to the vapor deposition film manufacturing apparatus described in claim 3, in the vapor deposition film manufacturing apparatus described in claim 1 or 2, the dielectric film caused to abut against the cooling roller is a dielectric film having one side which has already been subjected to metal vapor deposition with a metal identical to or different from a metal of the metal vapor, and the central angle is a predetermined central angle of more than 180° and 270° or less.

That is, according to the invention of claim 3, it is possible to manufacture a high-quality double-sided metal vapor deposition film or a high-quality single-sided multi-layer metal vapor deposition film.

When two cooling rollers are provided in the same apparatus, and metal vapor deposition is first performed on one side of the film, even if heat remains on the film, a wrap angle can be set larger, and the film can be suitably caused to adhere to the cooling roller, thereby preventing degradation in quality of the film due to thermal damage of the film at the time of second vapor deposition.

Further, even when only one cooling roller is provided, and second (or subsequent) metal vapor deposition is performed, stable vapor deposition is achieved without heating a metal membrane which has already been vapor-deposited.

According to the vapor deposition film manufacturing apparatus described in claim 4, in the vapor deposition film manufacturing apparatus described in claim 1 or 2, the chamber-inside pressure control unit is a unit for adjusting a supply amount of gas of the gas supply unit, or is a vacuum pump provided for the electron supply chamber.

That is, according to the invention of claim 4, it is possible to perform pressure control in a simple manner. In particular, when the unit for adjusting a supply amount of gas is formed of a valve (and a flow meter), an apparatus configuration is simplified.

In the vapor deposition film manufacturing apparatus described in claim 5, in the vapor deposition film manufacturing apparatus described in claim 1 or 2, the cooling roller is charged so that a pressure PD of the lower chamber, a pressure PU of the upper chamber, and a pressure PR of the electron supply chamber satisfy PD<PU<PR and 10PU≤PR≤1,000PU.

That is, according to the invention of claim 5, it is possible to maintain the cooling roller in a steady and proper charged state.

As shown in the examples above, PD: an order of 10⁻² Pa, PU: an order of 10⁻¹ Pa, and PR: an order of 10 Pa can be each taken as a standard.

### Advantageous Effects of Invention

According to the present invention, it is possible to manufacture a high-quality metal vapor deposition film by suitably and continuously charging the can-roller without causing an increase in size of the apparatus.

### Brief Description of Drawings

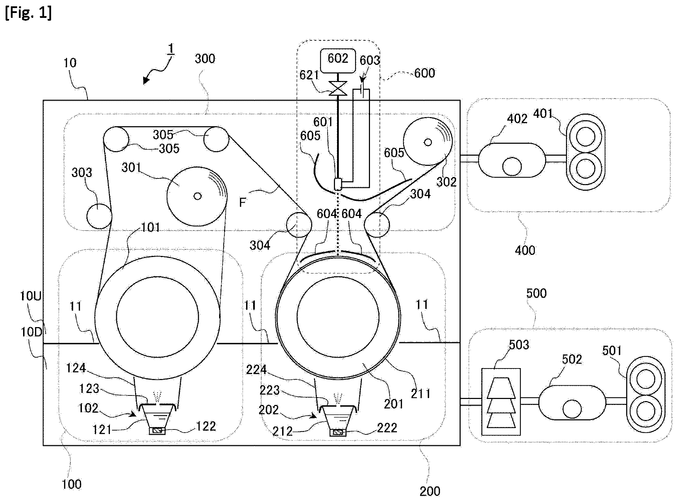

FIG. 1 is a sectional view for illustrating a configuration example of a double-sided vapor deposition film manufacturing apparatus to which a vapor deposition film manufacturing apparatus of the present invention is applied.

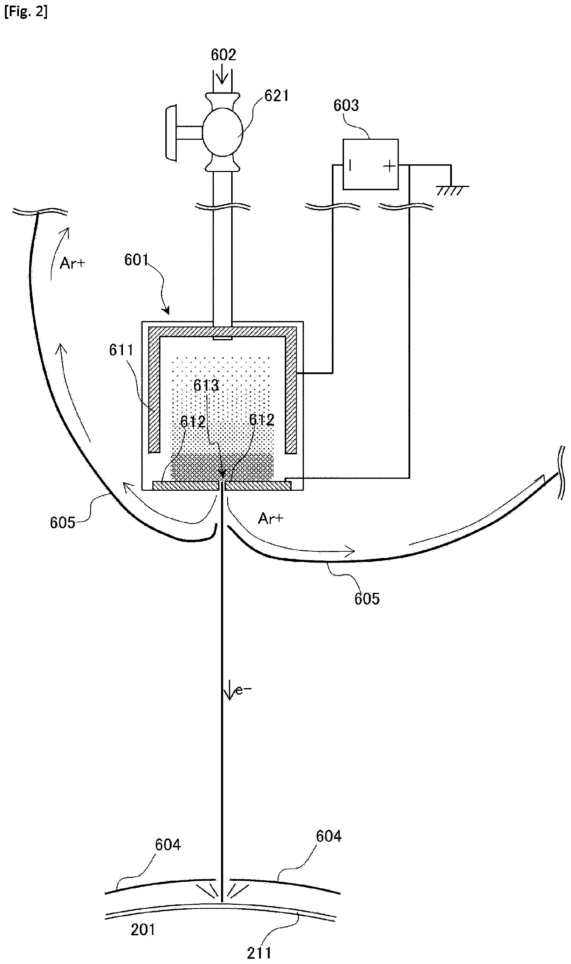

FIG. 2 is an enlarged schematic sectional view for illustrating an electron supply unit and a periphery thereof in an embodiment of the present invention. A situation in which electrons are moving toward a positive electrode side is illustrated by difference in density with four stages. It should be noted that for convenience of description, a scale of components in each of the figures does not necessarily reflect a scale ratio in an actual apparatus.

### Description of Embodiments

Hereinbelow, with reference to the drawings, detailed description is given of an embodiment of the present invention. Here, description is given of a vapor deposition film manufacturing apparatus for performing metal vapor deposition on both sides of a film.

FIG. 1 is a sectional view for illustrating a configuration example of a double-sided vapor deposition film manufacturing apparatus to which a vapor deposition film manufacturing apparatus of the present invention is applied.

For convenience of description, the double-sided vapor deposition film manufacturing apparatus is hereinafter simply referred to as "double-sided vapor deposition apparatus."

A double-sided vapor deposition apparatus 1 has a configuration mainly including a first vapor deposition unit 100, a second vapor deposition unit 200, a delivery/take-up unit 300, an upper-chamber vacuum unit 400, a lower-chamber vacuum unit 500, and an electron supply unit 600.

Of those, the first vapor deposition unit 100, the second vapor deposition unit 200, the delivery/take-up unit 300, and a part of the electron supply unit 600 are housed in a chamber 10. The chamber 10 is partitioned by partitions 11 into an upper chamber 10U and a lower chamber 10D with a can-roller 101 and a can-roller 201, which are described later, provided therebetween.

The first vapor deposition unit 100 includes the first can-roller 101 and a first evaporator 102.

The second vapor deposition unit 200 includes the second can-roller 201 and a second evaporator 202.

The delivery/take-up unit 300 includes a delivery roller 301, a take-up roller 302, a first restriction roller 303, second restriction rollers 304, and a plurality of auxiliary rollers 305.

The upper-chamber vacuum unit 400 includes a rotary pump 401 and a mechanical booster pump 402.

The lower-chamber vacuum unit 500 includes a rotary pump 501, a mechanical booster pump 502, and a diffusion pump 503.

The electron supply unit 600 includes an electron supply chamber 601, a gas cylinder 602, a power supply 603, a diffusion preventing cover 604, and a gas guide 605.

A film F is a dielectric film with a strip shape having a width of 50 cm and a thickness of 5.0 µm. Before being subjected to vapor deposition, the film F is a pure biaxially oriented polypropylene (OPP) film, is wrapped in a roll state, and then is attached to the delivery roller 301.

All of various rollers such as the delivery roller 301, the take-up roller 302, the first can-roller 101, and the second can-roller 201 are arranged so that respective axes thereof are parallel to each other and horizontal. The film F delivered from the delivery roller 301 passes through each of the rollers, and then is taken up in a roll state by the take-up roller 302 as the film F having both sides subjected to vapor deposition. Naturally, a length of each of the rollers is set longer than a width of the film F. A roller length of each of the rollers is set longer than a maximum film width generally used such that the rollers can be applied to various film widths, thereby enhancing general versatility of the double-sided vapor deposition apparatus 1.

An overview of double-sided vapor deposition to be performed by the double-sided apparatus 1 is as follows.

First, in the first vapor deposition unit 100, a metal vapor deposition layer is formed on one side of the film F continuously delivered from the delivery roller 301, by the first can-roller 101 and the first evaporator 102. Then, in the second vapor deposition unit 200, a metal vapor deposition layer is formed on a side of the film F which is opposite to the one side, by the second can-roller 201 having a surface coated with ceramics, and the second evaporator 202.

The film F is wrapped around (caused to abut against) each of the first can-roller 101 and the second can-roller 201 at a predetermined central angle, and then, metal vapor deposition is performed thereon from an outside. In particular, regarding the second can-roller 201, vapor deposition with higher adhesiveness is performed such that the film F is wrapped around the second can-roller 201 at a wrap angle of 240°, and a portion of the surface of the second can-roller 201, with which the film F is not in contact, is irradiated with an electron beam so as to continuously attract the film F to the second can-roller 201. Further, as described later, a possibility of occurrence of unintended discharge is significantly reduced by the diffusion preventing cover 604 and the gas guide 605.

The double-sided vapor deposition apparatus 1 together with a configuration thereof is described below in more detail.

The delivery roller 301 and the take-up roller 302 are rotated by a drive motor (not shown), and are controlled so that delivery and take-up speeds of the film F are each set to a constant speed of 100 m/min. This speed is variable, and can be appropriately changed in accordance with modes of specifications.

The delivered film F adheres to the first can-roller 101 at a central angle of about 180° based on a positional relationship between the delivery roller 301 and the first restriction roller 303.

The first can-roller 101 is a metal cylinder having a diameter of 60 cm and a width of 55 cm, and chromium plating is applied on a surface of the first can-roller 101 in order to enhance abrasion resistance, and the like. Further, the first can-roller 101 includes a cooling mechanism (not shown) inside the cylinder, and thus, a surface temperature thereof is maintained at -10°C. This temperature is variable, and can be appropriately changed in accordance with modes of specifications.

The first evaporator 102 is arranged in the lower chamber 10D, and includes: a crucible 121 extending long in an axial direction of the can-roller; and an electric heating element 122 for heating the crucible 121 from below. The first evaporator 102 evaporates a metal, in this case, zinc, which has been loaded thereinto. The crucible 121 is covered with a lid 123 having a slit, and the evaporated metal from the slit is sprayed on a surface of the film F. A partition 124 is also provided so as to prevent diffusion of the metal to other places. The metal is not particularly limited, and can be appropriately changed to aluminum or other metals in accordance with specifications required for a double-sided vapor deposition film.

Although not illustrated here, in the first vapor deposition unit 100, patterning using a masking oil may be appropriately performed, and a plurality of metal vapor deposition layers may be formed on one side of the film, for example, with use of a plurality of evaporators.

The film F having the one side with the metal layer formed thereon is delivered to the second vapor deposition unit 200 via the auxiliary rollers 305. Here, the film F adheres to the second can-roller 201 at a central angle (wrap angle) of about 240° based on a positional relationship between two second restriction rollers 304, and in order to perform metal vapor deposition on the side opposite to the one side previously subjected to vapor deposition, each of the various rollers is arranged so that the side of the film F having the vapor deposition layer formed in the first vapor deposition unit 100 faces in a direction adhering to the second can-roller 201.

The second can-roller 201 is a metal cylinder having a diameter of 60 cm and a width of 55 cm, and the surface thereof is coated with ceramics containing alumina and titania and having a thickness of 50 um (an insulating layer 211 is formed on the surface) . A material and a thickness of the insulating layer 211 can be appropriately changed in accordance with modes of specifications, and as the material, besides a combination of alumina and titania, for example, only alumina or only titania may be used. In addition, the thickness may be from 10 um to 100 um. Further, the second can-roller 201 includes a cooling mechanism (not shown) inside the cylinder, and thus, a surface temperature thereof is maintained at -15°C. This temperature is variable, and can be appropriately changed. In the second can-roller 201, the wrap angle for the film F is set larger so as to enhance adhesiveness of the film to the can-roller due to a dielectric action, thereby preventing thermal damage of the film, and hence, even at the time of second metal vapor deposition, reliability in quality of the film can be improved.

The second evaporator 202 is arranged in the lower chamber 10D, and includes: a crucible 221 extending long in an axial direction of the can-roller; and an electric heating element 222 for heating the crucible 221 from below. As in the first evaporator 102, the second evaporator 202 evaporates zinc. The crucible 221 is covered with a lid 223 having a slit, and the evaporated metal from the slit is sprayed on a surface of the film F (pure OPP surface) . A partition 224 is also provided so as to prevent diffusion of the metal to other places. The metal is not particularly limited, and can be appropriately changed to aluminum or other metals in accordance with specifications required for a double-sided vapor deposition film.

Further, as in the first vapor deposition unit 100, patterning using a masking oil may be appropriately performed, and a plurality of metal vapor deposition layers may be formed on one side of the film, for example, with use of a plurality of evaporators. In this case, there may be provided a control mechanism for performing positioning with respect to a pattern of the opposite side of the film which has already been subjected to vapor deposition.

The upper-chamber vacuum unit 400 maintains the upper chamber 10U at a predetermined vacuum degree (pressure PU) . In this embodiment, specifically, vacuuming is performed so as to maintain the pressure PU at 10⁻¹ Pa. Accordingly, the mechanical booster pump 402 is connected to the upper chamber 10U, and the rotary pump 401 is connected to the mechanical booster pump 402, thereby performing deaeration.

The lower-chamber vacuum unit 500 maintains the lower chamber 10D at a predetermined vacuum degree (pressure PD) . In this embodiment, specifically, vacuuming is performed so as to maintain the pressure PD at 10⁻² Pa. The lower chamber 10D has a higher vacuum degree, and thus, the diffusion pump 503 is first connected to the lower chamber 10D. Then, the mechanical booster pump 502 is connected to the diffusion pump 503, and the rotary pump 501 is connected to the mechanical booster pump 502.

Clearances of the partitions 11 (interval between each of the partitions 11 and the first can-roller 101, and interval between each of the partitions 11 and the second can-roller 201) are each narrowed to such an extent as to be able to satisfy PU×0.1≥PD∼10⁻² Pa.

In a case of providing no partition 11, it is required that the entire chamber 10 be subjected to vacuuming to a vacuum degree for vapor deposition so as to achieve high vacuum. Thus, it takes time before start of manufacturing (start of vapor deposition), resulting in degradation of workability. When the diffusion pump 503 with higher performance is introduced, this lead time can sometimes be set to be equal to that in a case in which the partitions 11 are provided. However, the entire apparatus would be increased in size and cost.

In the second vapor deposition unit 200, the second can-roller 201 is irradiated with an electron beam by the electron supply chamber 601. The film F has the metal layer formed thereon, and thus, at the beginning of beam application, a part of irradiated electrons is dissipated to, for example, the take-up roller 302 side, but equipotential is formed immediately. As described later, the second can-roller 201 is continuously irradiated with the electron beam from the electron supply chamber 601, and hence, the second can-roller 201 can be continuously charged. Accordingly, even when the metal layer is present between the film F and the second can-roller 201, a dielectric film portion (pure film portion) of the film F is attracted to the second can-roller 201 side, thereby increasing the degree of adhesion. As a result, a quality and reliability of the film are improved.

FIG. 2 is an enlarged schematic sectional view for illustrating the electron supply unit 600 and a periphery thereof in this embodiment. The electron supply chamber 601 is illustrated as a sectional view obtained by cutting the electron supply chamber 601 in a direction perpendicular to the axial direction of the can-roller.

The electron supply chamber 601 is a rectangular parallelepiped that is longitudinal in one direction, and a longitudinal direction thereof is oriented parallel to the axis of the can-roller 201. Here, a size of the electron supply chamber 601 is set to 510 mm×45 mm×45 mm. Further, an interval between the can-roller 201 and the electron supply chamber 601 is set to 150 mm.

The electron supply chamber 601 includes; a hollow cathode 611 having a substantially U-shape in section; and a positive electrode 612, and a slit 613 having a width of 1 mm is provided in the positive electrode 612 in a longitudinal direction thereof.

Argon gas is supplied from the gas cylinder 602 into the hollow cathode 611. A supply amount of argon gas depends on an applied voltage, a ratio of a sectional area of the electron supply chamber 601 to an interval of the slit 613 (leakage amount of argon gas into the upper chamber 10U), and the like. However, when the supply amount as converted under normal pressure is set to from 5 cc to 30 cc per minute, the argon gas can be brought into a proper ionized state. Here, the supply amount is set to 10 cc per minute.

The supply amount of argon gas is adjusted by a valve 621. When the supply amount is 10 cc per minute, a pressure PR inside the electron supply chamber 601 is maintained at 10 Pa. When a hollow cathode is used, the supply amount is preferably adjusted so as to satisfy 10PU≤PR≤1,000PU.

The power supply 603 is a DC power supply, causes the positive electrode 612 to be grounded, and supplies such a voltage as to bring a negative electrode, that is, the hollow cathode 611 side, into a stable plasma state. Here, the voltage is set to -10 kV. Due to this potential difference, argon gas supplied into the hollow cathode 611 is stably ionized. In the figure, the power supply is schematically drawn, but naturally, a circuit may be appropriately configured therein.

Electrons generated by ionization are attracted to the positive electrode 612 side, and a part of the electrons passes through the slit 613, and is steadily applied to the can-roller 201 as an electron beam in a linear shape along the axis of the can-roller 201, substantially without spreading.

In this case, a part of the applied electrons rebounds on the can-roller 201, and thus, is diffused on the upper chamber 10U side. In order to prevent this, the diffusion preventing cover 604 is arranged close to the can-roller 201. The diffusion preventing cover 604 is a curved surface plate that is longitudinal in the axial direction of the can-roller 201 and has a section with an arc shape along the surface of the can-roller 201. Due to presence of the diffusion preventing cover 604, the electrons after rebounding are caused to move again toward the surface of the can-roller 201, thereby preventing discharge from occurring at an unintended place, and hence a desired dielectric effect (adhesive effect of the film) can be achieved. In accordance with modes of specifications, an end portion of the diffusion preventing cover 604 and an end portion of the can-roller may be brought into sliding contact with each other so as to form an equipotential surface.

The diffusion preventing cover 604 is, so to speak, a curved surface plate having an elongated hole formed at the center thereof, and is also required to have a shape with an interval between the diffusion preventing cover 604 and the film F. Thus, a small part of the electrons are leaked out from such gaps into the upper chamber 10U in some cases.

When the double-sided vapor deposition apparatus 1 is continuously operated, there are generated a portion in which such a small number of leaked electrons collect or easily gather (this portion is liable to depend on a shape of the apparatus and arrangement of each of parts) . If such a portion is left as it is, abnormal discharge may be caused, and thus, in order to prevent the abnormal discharge, the gas guide 605 is provided in the electron supply unit 600 so as to direct positively charged Ar⁺ gas leaked out from the slit 613 to the portion. In this embodiment, the gas guide 605 is arranged so that Ar⁺ gas flows toward the take-up roller 302. Accordingly, even if electrons collect near the take-up roller 302, such a portion is neutralized, thereby achieving prevention of discharge with respect to a product film having both sides subjected to vapor deposition.

In the related art in which the voltage is applied to the can-roller itself, in a case in which the metal layer side of the film abuts against the surface of the can-roller, when the surface of the can-roller is made of a metal, it is substantially impossible to charge the can-roller (impossible to cause attraction and adhesion of the film thereto). When the insulating layer is provided on the surface of the can-roller, it is possible to charge the can-roller. However, a thickness of the insulating layer is required to be set to be at least several times larger than that of the film, an attractive force is proportional to the square of a voltage, and is inversely proportional to the square of a distance (thickness), and hence, due to interference of the insulating layer, an adhesive effect is reduced to about one several tenths. When, in anticipation of this, the applied voltage is increased, a desired attractive force can be generated with respect to the film. However, in this case, due to the inside of the chamber 10 having been subjected to vacuuming, and the like, abnormal discharge is liable to occur, thereby damaging the film.

In the second vapor deposition unit 200, not by a potential difference, but by directly and continuously charging the can-roller 201, effective adhesion is achieved. Further, the wrap angle is set larger, and hence, the film F is cooled sufficiently, thereby preventing thermal damage of the film F. Thus, a quality of vapor deposition is maintained and improved.

A predetermined tension is applied to the film F by the restriction rollers and the auxiliary rollers, and accordingly, adhesiveness of the film to the can-roller is enhanced. In accordance with modes of specifications, a voltage applying mechanism may be provided to each of the first restriction roller 303 and the second restriction rollers 304 so that the film F is caused to have a polarity via the mechanism, thereby improving the degree of adhesion with respect to the can-roller.

As described above, in the double-sided vapor deposition apparatus 1, the upper chamber 10U is not required to be not only entirely but also locally set to a vacuum degree as in the lower chamber 10D, and a vacuum pump system, and consequently, an increase in size of an apparatus configuration is not caused. Thus, a high-quality double-sided metal vapor deposition film can be manufactured. Generation and irradiation of a stable electron beam are achieved by only adjusting the valve 621, and hence, operability is also excellent.

The embodiment of the present invention is not limited to the above-mentioned configuration.

For example, a configuration may be employed in which a charge-removal mechanism is provided immediately near the delivery roller 301 and the take-up roller 302, or the first restriction roller 303 and the second restriction rollers 304 so as to perform removal of charge on the film. Even when removal of charge is continuously or intermittently performed during vapor deposition, the surface of the second can-roller 201 is maintained in a predetermined charged state by the electron supply unit 600, and hence, the film is continuously attracted to the can-roller.

Further, the present invention can be implemented as, instead of an apparatus for performing continuous double-sided vapor deposition, a single-sided vapor deposition apparatus with the first vapor deposition unit 100 omitted. In addition, the present invention can be used as a double-sided vapor deposition apparatus for performing vapor deposition on a side opposite to one side of a roll which has already been subjected to vapor deposition.

### Industrial Applicability

In order to improve the degree of adhesion of the first can-roller 101 with respect to the film, an electron supply chamber can be also provided in the first vapor deposition unit 100.

### Reference Signs List

- 1: double-sided vapor deposition apparatus
- 10: chamber
- 10D: lower chamber
- 10U: upper chamber
- 11: partition
- 100: first vapor deposition unit
- 101: first can-roller
- 200: second vapor deposition unit
- 201: second can-roller
- 202: second evaporator
- 211: insulating layer
- 221: crucible
- 222: electric heating element
- 223: lid
- 224: partition
- 300: delivery/take-up unit
- 301: delivery roller
- 302: take-up roller
- 400: upper-chamber vacuum unit
- 401: rotary pump
- 402: mechanical booster pump
- 500: lower chamber vacuum unit
- 501: rotary pump
- 502: mechanical booster pump
- 503: diffusion pump
- 600: electron supply unit
- 601: electron supply chamber
- 602: gas cylinder
- 603: power supply
- 604: diffusion preventing cover
- 605: gas guide
- 611: hollow cathode
- 612: positive electrode
- 613: slit
- 621: valve

## Claims

1. A vapor deposition film manufacturing apparatus, which is partitioned into an upper chamber and a lower chamber with a cooling roller having a circular column shape provided therebetween,
the cooling roller being arranged so that an axis thereof is horizontal, and being configured to rotate to feed a dielectric film having a strip shape while causing the dielectric film caused to abut against the cooling roller over a predetermined central angle on the lower chamber side,
the vapor deposition film manufacturing apparatus comprising:
a evaporation unit, which is arranged in the lower chamber, and is configured to diffuse metal vapor toward the dielectric film;
a lower-chamber vacuum pump, which is in communication with the lower chamber, and is configured to maintain the lower chamber at a first predetermined vacuum degree;
an upper-chamber vacuum pump, which is in communication with the upper chamber, and is configured to maintain the upper chamber at a second predetermined vacuum degree;
an electron supply chamber, which houses therein a hollow cathode, has a columnar outer shape, and is arranged so that a longitudinal direction of the electron supply chamber is parallel to the axis;
a gas supply unit configured to supply gas for ionization into the electron supply chamber;
chamber-inside pressure control unit for maintaining an inside of the electron supply chamber at a third predetermined vacuum degree; and
a power supply unit configured to ionize gas inside the electron supply chamber via the hollow cathode,
wherein a slit for electron emission is provided in the electron supply chamber so as to be parallel to the axis, and is opened toward a portion of a surface of the cooling roller, which is not covered with the dielectric film,
wherein a prevention body is provided between the electron supply chamber and the cooling roller, and is configured to prevent electrons from diffusing to the upper chamber side due to rebound of the electrons from the cooling roller side, and
wherein, while adhesiveness of the dielectric film to the cooling roller is enhanced by charging the surface of the cooling roller, occurrence of unintended discharge in the upper chamber is suppressed.

2. The vapor deposition film manufacturing apparatus according to claim 1, wherein a guide body is provided in the upper chamber, and is configured to direct gas positively charged and leaked out from the slit, to a predetermined direction.

3. The vapor deposition film manufacturing apparatus according to claim 1 or 2,
wherein the dielectric film caused to abut against the cooling roller is a dielectric film having one side which has already been subjected to metal vapor deposition with a metal identical to or different from a metal of the metal vapor, and
wherein the central angle is a predetermined central angle of more than 180° and 270° or less.

4. The vapor deposition film manufacturing apparatus according to claim 1 or 2, wherein the chamber-inside pressure control unit is a unit for adjusting a supply amount of gas of the gas supply unit, or is a vacuum pump provided for the electron supply chamber.

5. The vapor deposition film manufacturing apparatus according to claim 1 or 2, wherein the cooling roller is charged so that a pressure PD of the lower chamber, a pressure PU of the upper chamber, and a pressure PR of the electron supply chamber satisfy PD<PU<PR and 10PU≤PR≤1,000PU.
